# EUROPEAN PATENT APPLICATION

(11) **EP 4 573 944 A1**
(43) Date of publication of application: **25.06.2025**
(21) Application number: 22955703.8
(22) Date of filing: 17.08.2022
(51) Int. Cl.: A24F 40/53

(54) **INHALATION DEVICE, CONTROL METHOD, AND PROGRAM**

(71) Applicant: Japan Tobacco Inc., Tokyo 105-6927 (JP)
(72) Inventor: TEZUKA, Hiroshi, Tokyo 130-8603 (JP)
(74) Representative: Hoffmann Eitle
(86) International application number: PCT/JP2022/031133
(87) International publication number: WO 2024/038529

(57) **Abstract**

This inhalation device (100B), which generates an aerosol from a stick-type base material (150) having an aerosol source, comprises a first operation button and a second operation button that can be operated by a user, and a control unit (116B) for controlling the operation of the inhalation device (100B). The first operation button and the second operation button are configured so as to be able to assume a shielded state in which the buttons are covered by another member and are hardly noticeable by the user. The control unit (116B) restricts a prescribed operation of the inhalation device (100B) until a prescribed cancellation operation using the first operation button and the second operation button is performed.

## Description

### TECHNICAL FIELD

The present invention relates to an inhalation device, a control method, and a program.

### BACKGROUND ART

In the related art, for example, there is known an inhaler that generates an aerosol to which a flavor component is applied and allows a user to inhale the generated aerosol. Such an inhaler typically delivers, to the user, the aerosol generated by heating a base material containing an aerosol source with a heating unit (also referred to as a "heating element") which is an electrical resistance heater or an induction heater. Further, such an inhaler also has a so-called "child resistance function" in order to prevent an occurrence of inconvenience caused by misuse by a child (for example, an infant and a young child).

For example, Patent Literature 1 below discloses that, in order to restrict access to contents of a container, a combination of two or more different operations such as squeezing while rotating a cap is required, as the child resistance function.

Further, Patent Literature 2 below discloses that a mouthpiece that moves relative to a main body portion between a first position and a second position to switch a device between a stopped state and an operating state is biased toward the first position by a spring or the like, and the device is maintained in the stopped state against a predetermined biasing force. It is disclosed that the predetermined biasing force can be selected to exceed a normal force of the infants (an expected hand force) in order to set the switching of the device in the operating state to be child-resistant.

### CITATION LIST

### PATENT LITERATURE

Patent Literature 1: JP2020-506121A
Patent Literature 2: JP2019-505190A

### SUMMARY OF INVENTION

### TECHNICAL PROBLEM

However, a history of the technical development of the inhaler is still young. Therefore, there is a room for improvement in the child resistance function of the inhaler from a viewpoint of improving a performance.

The present invention is to provide an inhalation device, a control method, and a program capable of further preventing an occurrence of inconvenience caused by misuse by a child.

### SOLUTION TO PROBLEM

A first aspect of the present invention is an inhalation device that generates an aerosol from a base material including an aerosol source, the inhalation device including:
a first operation unit and a second operation unit configured to be operated by a user; and
a control unit configured to control an operation of the inhalation device,
each of the first operation unit and the second operation unit is configured to be covered with another member and enter a shielded state where it is difficult for the user to visually recognize the corresponding operation unit, in which
the control unit restricts a predetermined operation in the inhalation device until a predetermined release operation using the first operation unit and the second operation unit is performed.

A second aspect of the present invention is a control method to be performed by a computer for controlling an operation of an inhalation device that generates an aerosol from a base material including an aerosol source,
the inhalation device including a first operation unit and a second operation unit configured to be operated by a user,
each of the first operation unit and the second operation unit being configured to be covered with another member and enter a shielded state where it is difficult for the user to visually recognize the corresponding operation unit,
the control method including the computer performing the following processing:
   restricting a predetermined operation in the inhalation device until a predetermined release operation using the first operation unit and the second operation unit is performed.

A third aspect of the present invention is a program to be executed by a computer for controlling an operation of an inhalation device that generates an aerosol from a base material including an aerosol source,
the inhalation device including a first operation unit and a second operation unit configured to be operated by a user,
each of the first operation unit and the second operation unit being configured to be covered with another member and enter a shielded state where it is difficult for the user to visually recognize the corresponding operation unit,
the program causing the computer to perform the following processing:
   restricting a predetermined operation in the inhalation device until a predetermined release operation using the first operation unit and the second operation unit is performed.

### ADVANTAGEOUS EFFECTS OF INVENTION

According to the present invention, an inhalation device, a control method, and a program capable of further preventing an occurrence of inconvenience caused by misuse by a child can be provided.

### BRIEF DESCRIPTION OF DRAWINGS

[FIG. 1A] FIG. 1A is a schematic diagram schematically illustrating a first configuration example of an inhalation device.
[FIG. 1B] FIG. 1B is a schematic diagram schematically illustrating a second configuration example of the inhalation device.
[FIG. 2] FIG. 2 is an overall perspective view of an inhalation device 100B.
[FIG. 3] FIG. 3 is a top view of the inhalation device 100B.
[FIG. 4] FIG. 4 is a diagram illustrating the inhalation device 100B in a state where a panel 10 is removed therefrom.
[FIG. 5] FIG. 5 is a diagram illustrating a first example of specific operations of an inhalation device 100.
[FIG. 6] FIG. 6 is a diagram showing a modification of a light emitting device 23a.
[FIG. 7] FIG. 7 is a diagram illustrating a second example of the specific operations of the inhalation device 100.
[FIG. 8] FIG. 8 is a diagram illustrating an example of a display device 23b.
[FIG. 9] FIG. 9 is a diagram illustrating a third example of the specific operations of the inhalation device 100.
[FIG. 10] FIG. 10 is a diagram illustrating a fourth example of the specific operations of the inhalation device 100.
[FIG. 11] FIG. 11 is a flowchart (part 1) illustrating an example of processing performed by a control unit 116.
[FIG. 12] FIG. 12 is a flowchart (part 2) illustrating an example of the processing performed by the control unit 116.
[FIG. 13] FIG. 13 is a diagram illustrating a modification of the inhalation device 100.
[FIG. 14] FIG. 14 is a diagram illustrating an example of a first heating profile Pr1 used for main heating control after a first release operation is performed and a second heating profile Pr2 used for main heating control after a second release operation is performed.

### DESCRIPTION OF EMBODIMENTS

Hereinafter, an inhalation device, a control method, and a program according to an embodiment of the present invention will be described with reference to the drawings. Hereinafter, the same or similar elements are denoted by the same or similar reference numerals, and the description thereof may be appropriately omitted or simplified.

### «1 Configuration Example of Inhalation Device»

An inhalation device of the present embodiment is a device that generates a substance to be inhaled by a user. Hereinafter, the substance generated by the inhalation device will be described as an aerosol. Further, the substance generated by the inhalation device may be a gas.

### (1) First Configuration Example

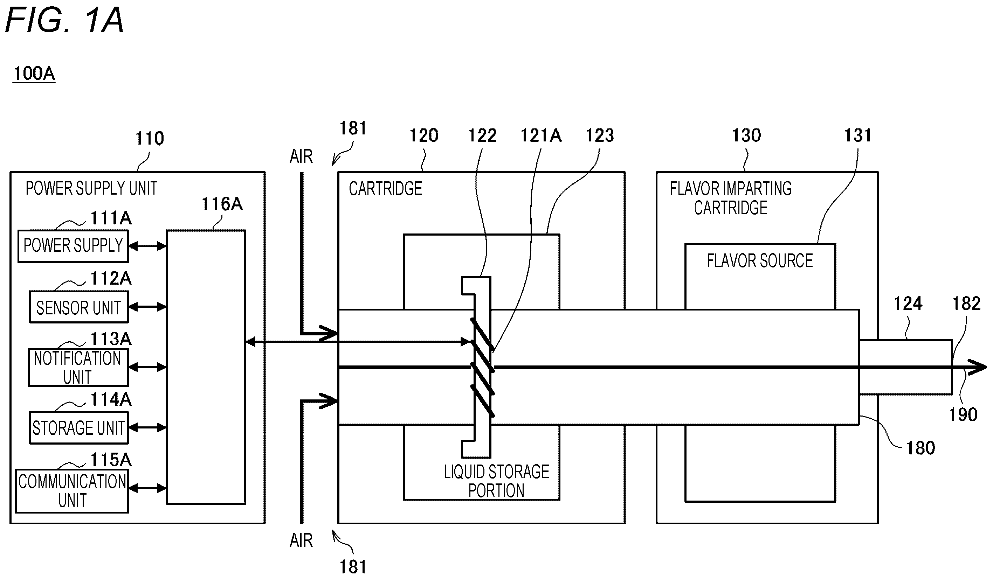

FIG. 1A is a schematic diagram schematically illustrating a first configuration example of the inhalation device. As illustrated in FIG. 1A, an inhalation device 100A according to the present configuration example includes a power supply unit 110, a cartridge 120, and a flavor imparting cartridge 130. The power supply unit 110 includes a power supply 111A, a sensor unit 112A, a notification unit 113A, a storage unit 114A, a communication unit 115A, and a control unit 116A. The cartridge 120 includes a heating unit 121A, a liquid guide portion 122, and a liquid storage portion 123. The flavor imparting cartridge 130 includes a flavor source 131 and a mouthpiece 124. An air flow path 180 is formed in the cartridge 120 and the flavor imparting cartridge 130.

The power supply 111A stores electric power. The power supply 111A supply the electric power to each component of the inhalation device 100A under control of the control unit 116A. The power supply 111A may be implemented by, for example, a rechargeable battery such as a lithium-ion secondary battery.

The sensor unit 112A acquires various types of information related to the inhalation device 100A. As an example, the sensor unit 112A is implemented by a pressure sensor such as a condenser microphone, a flow rate sensor, a temperature sensor, or the like, and acquires a value associated with inhalation of the user. As another example, the sensor unit 112A is implemented by an input device for receiving an input of information from the user, such as an operation button or a switch.

For example, the sensor unit 112A includes a pressure sensor (also referred to as a "puff sensor") that detects a change in a pressure (that is, an internal pressure) inside the inhalation device 100A caused by the inhalation of the user. Further, the sensor unit 112A may include a flow rate sensor that detects a flow rate generated by the inhalation of the user, and a temperature sensor (also referred to as a "puff thermistor") that detects a temperature of the heating unit 121A or around the heating unit 121A.

In the present embodiment, the sensor unit 112A may include a panel detection sensor that detects whether a panel 10 to be described later is attached to a main body housing 20. The panel detection sensor may be implemented by, for example, a magnetic sensor (for example, a Hall sensor) that detects a magnetic force based on a magnetic field applied from a magnet provided on the panel 10 to be described later. Further, the sensor unit 112A may include a sensor that detects an attachment state of a base material such as the cartridge 120 or the flavor imparting cartridge 130.

The notification unit 113A notifies the user of the information. Examples of the notification unit 113A include a light emitting device (for example, a light emitting device 23a to be described later) that emits light, a display device (for example, a display device 23b to be described later) that displays an image, a sound output device that outputs sound, or a vibration device that vibrates.

The storage unit 114A stores various types of information for an operation of the inhalation device 100A. The storage unit 114A is implemented by, for example, a nonvolatile storage medium such as a flash memory.

The communication unit 115A is a communication interface capable of performing communication conforming to any wired or wireless communication standard. As such a communication standard, for example, a standard using Wi-Fi (registered trademark), Bluetooth (registered trademark), Bluetooth Low Energy (BLE (registered trademark)), Near Field Communication (NFC), or Low Power Wide Area (LPWA) may be adopted.

The control unit 116A functions as an arithmetic processing device and a control device, and controls overall operations in the inhalation device 100A according to various programs. The control unit 116A is implemented by, for example, an electronic circuit such as a central processing unit (CPU) or a microprocessor.

The liquid storage portion 123 stores an aerosol source. That is, the cartridge 120 including the liquid storage portion 123 for storing the aerosol source is an example of a base material including the aerosol source. The aerosol source is atomized to generate an aerosol. The aerosol source is, for example, a liquid such as water or a polyhydric alcohol such as glycerin and propylene glycol. The aerosol source may contain a flavor component derived from tobacco or non-tobacco. When the inhalation device 100A is a medical inhaler such as a nebulizer, the aerosol source may include a medical agent.

The liquid guide portion 122 guides the aerosol source, which is a liquid stored in the liquid storage portion 123, from the liquid storage portion 123 and holds the aerosol source. The liquid guide portion 122 is, for example, a wick formed by twisting a fibrous material such as glass fibers or a porous material such as porous ceramics. In that case, the aerosol source stored in the liquid storage portion 123 is induced by a capillary effect of the wick.

The heating unit 121A heats the aerosol source to atomize the aerosol source to generate the aerosol. In the example illustrated in FIG. 1A, the heating unit 121A is implemented by a coil and wound around the liquid guide portion 122. When the heating unit 121A generates heat, the aerosol source held by the liquid guide portion 122 is heated and atomized, and the aerosol is generated. The heating unit 121A generates heat when supplied with power from the power supply 111A. As an example, the heating unit 121A may be supplied with power when the sensor unit 112A detects that the user starts the inhalation and/or that predetermined information is input. Further, when the sensor unit 112A detects that the user finishes the inhalation and/or that predetermined information is input, the supply of power to the heating unit 121A may be stopped. An inhalation operation of the user with respect to the inhalation device 100A can be detected, for example, based on the fact that the pressure (internal pressure) inside the inhalation device 100A detected by the puff sensor exceeds a predetermined threshold.

The flavor source 131 is a component for imparting the flavor component to the aerosol. The flavor source 131 may contain the flavor component derived from tobacco or non-tobacco.

The air flow path 180 is a flow path of air inhaled by the user. The air flow path 180 has a tubular structure having an air inflow hole 181 which is an inlet of air into the air flow path 180 and an air outflow hole 182 which is an outlet of air from the air flow path 180 as both ends. In the middle of the air flow path 180, the liquid guide portion 122 is disposed on an upstream side (a side close to the air inflow hole 181), and the flavor source 131 is disposed on a downstream side (a side close to the air outflow hole 182). The air flowing in from the air inflow hole 181 in response to the inhalation of the user is mixed with the aerosol generated by the heating unit 121A, passes through the flavor source 131, and is transported to the air outflow hole 182 as indicated by an arrow 190. When a mixed fluid of the aerosol and the air passes through the flavor source 131, the flavor component contained in the flavor source 131 is imparted to the aerosol.

The mouthpiece 124 is a member that can be held by the user in his/her mouth during the inhalation. The air outflow hole 182 is disposed in the mouthpiece 124. The user can take in the mixed fluid of the aerosol and the air into the oral cavity by holding the mouthpiece 124 in his/her mouth and inhaling the mouthpiece 124.

The configuration example of the inhalation device 100A has been described above. It is needless to say that the configuration of the inhalation device 100A is not limited to the above, and may adopt various configurations as exemplified below.

As an example, the inhalation device 100A may not include the flavor imparting cartridge 130. In this case, the mouthpiece 124 is provided on the cartridge 120.

As another example, the inhalation device 100A may further include a second heating unit that heats the flavor source 131. In this case, the second heating unit is formed in a film shape, for example, and is disposed to cover an outer periphery of the flavor imparting cartridge 130. Then, the second heating unit generates heat when being supplied with electric power from the power supply 111A, and heats the flavor imparting cartridge 130 from the outer periphery. By providing such a second heating unit, a temperature of the flavor source 131 can be increased and an amount of the flavor component applied to the aerosol can be increased, as compared with a case where the second heating unit is not provided. When such a second heating unit is provided, the second heating unit is controlled such that an actual temperature becomes a predetermined target temperature, for example, similarly to a heating unit 121B to be described later. Hereinafter, the inhalation device 100A including such a second heating unit will be referred to a "hybrid-type inhalation device 100A".

As another example, the inhalation device 100A may include a plurality of types of aerosol sources. A plurality of types of aerosols generated from the plurality of types of aerosol sources may be mixed in the air flow path 180 to cause a chemical reaction, thereby generating another type of aerosol.

A method for atomizing the aerosol source is not limited to heating by the heating unit 121A. For example, the method for atomizing the aerosol source may be vibratory atomization or induction heating.

### (2) Second Configuration Example

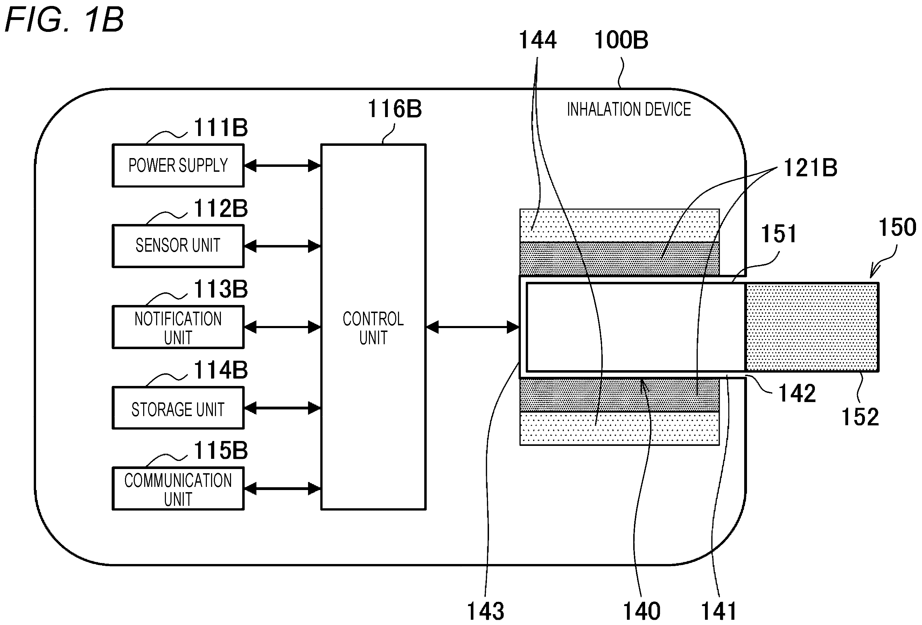

FIG. 1B is a schematic diagram schematically illustrating a second configuration example of the inhalation device. As illustrated in FIG. 1B, an inhalation device 100B according to the present configuration example includes a power supply 111B, a sensor unit 112B, a notification unit 113B, a storage unit 114B, a communication unit 115B, a control unit 116B, a heating unit 121B, an accommodating portion 140, and a heat insulating portion 144.

The power supply 111B, the sensor unit 112B, the notification unit 113B, the storage unit 114B, the communication unit 115B, and the control unit 116B are substantially the same as the corresponding components provided in the inhalation device 100A according to the first configuration example.

The accommodating portion 140 has an internal space 141, and holds the stick-type base material 150 while accommodating a part of the stick-type base material 150 in the internal space 141. The accommodating portion 140 has an opening 142 through which the internal space 141 communicates with the outside, and holds the stick-type base material 150 inserted into the internal space 141 from the opening 142. For example, the accommodating portion 140 is a cylindrical body having the opening 142 and a bottom portion 143 as a bottom surface, and defines the columnar internal space 141. An air flow path for supplying air to the internal space 141 is connected to the accommodating portion 140. An air inflow hole, which is an inlet of air to the air flow path, is disposed, for example, in a side surface of the inhalation device 100. An air outflow hole, which is an outlet of air from the air flow path to the internal space 141, is disposed, for example, in the bottom portion 143.

The stick-type base material 150 includes a base material portion 151 and an inhalation port portion 152. The base material portion 151 includes the aerosol source. That is, the stick-type base material 150 is another example of the base material including the aerosol source. The aerosol source contains the flavor component derived from tobacco or non-tobacco. When the inhalation device 100B is a medical inhaler such as a nebulizer, the aerosol source may include a medical agent. For example, the aerosol source may be a liquid such as water and polyhydric alcohols such as glycerin and propylene glycol, including the flavor component derived from tobacco or non-tobacco, or may be a solid including the flavor component derived from tobacco or non-tobacco. In a state where the stick-type base material 150 is held by the accommodating portion 140, at least a part of the base material portion 151 is accommodated in the internal space 141, and at least a part of the inhalation port portion 152 protrudes from the opening 142. When the user holds the inhalation port portion 152 protruding from the opening 142 in his/her mouth and inhales, air flows into the internal space 141 through an air flow path that is not illustrated, and reaches the oral cavity of the user together with the aerosol generated from the base material portion 151.

In the example illustrated in FIG. 1B, the heating unit 121B is formed in a film shape, and is disposed to cover an outer periphery of the accommodating portion 140. Then, when the heating unit 121B generates heat, the base material portion 151 of the stick-type base material 150 is heated from the outer periphery thereof, and the aerosol is generated.

The heat insulating portion 144 prevents heat transfer from the heating unit 121B to other components. For example, the heat insulating portion 144 is made of a vacuum heat insulating material or an aerogel heat insulating material.

The configuration example of the inhalation device 100B has been described above. It is needless to say that the configuration of the inhalation device 100B is not limited to the above, and may adopt various configurations as exemplified below.

As an example, the heating unit 121B may be formed in a blade shape and disposed to protrude from the bottom portion 143 of the accommodating portion 140 into the internal space 141. In this case, the blade-shaped heating unit 121B is inserted into the base material portion 151 of the stick-type base material 150, and heats the base material portion 151 of the stick-type base material 150 from the inside. As another example, the heating unit 121B may be disposed to cover the bottom portion 143 of the accommodating portion 140. Further, the heating unit 121B may be configured as a combination of two or more of a first heating unit covering the outer periphery of the accommodating portion 140, a blade-shaped second heating unit, and a third heating unit covering the bottom portion 143 of the accommodating portion 140.

As another example, the accommodating portion 140 may include an opening and closing mechanism such as a hinge that opens and closes a part of an outer shell forming the internal space 141. The accommodating portion 140 may open and close the outer shell to sandwich and accommodate the stick-type base material 150 inserted into the internal space 141. In this case, the heating unit 121B may be provided at a sandwiching place in the accommodating portion 140, and may heat the stick-type base material 150 while pressing the stick-type base material 150.

The method for atomizing the aerosol source is not limited to heating by the heating unit 121B. For example, the method for atomizing the aerosol source may be induction heating. In this case, the inhalation device 100B at least includes an electromagnetic induction source such as a coil for generating a magnetic field, instead of the heating unit 121B. A susceptor that generates heat due to the induction heating may be provided in the inhalation device 100B or may be provided in the stick-type base material 150.

The inhalation device 100B may further include the heating unit 121A, the liquid guide portion 122, the liquid storage portion 123, and the air flow path 180 according to the first configuration example, and the air flow path 180 may supply air to the internal space 141. In this case, the mixed fluid of the aerosol and the air generated by the heating unit 121A flows into the internal space 141, is further mixed with the aerosol generated by the heating unit 121B, and reaches the oral cavity of the user.

### <<2. External Configuration Example of Inhalation Device>>

Next, an external configuration example of an inhalation device 100 (100A, 100B) of the present embodiment will be described. Here, the inhalation device 100 is described as being the inhalation device 100B illustrated in FIG. 1B, but the present invention is not limited thereto, and the same can be applied to a case where the inhalation device 100 is the inhalation device 100A illustrated in FIG. 1A or a hybrid-type inhalation device 100A.

### (1) Example of Inhalation Device with Panel Attached

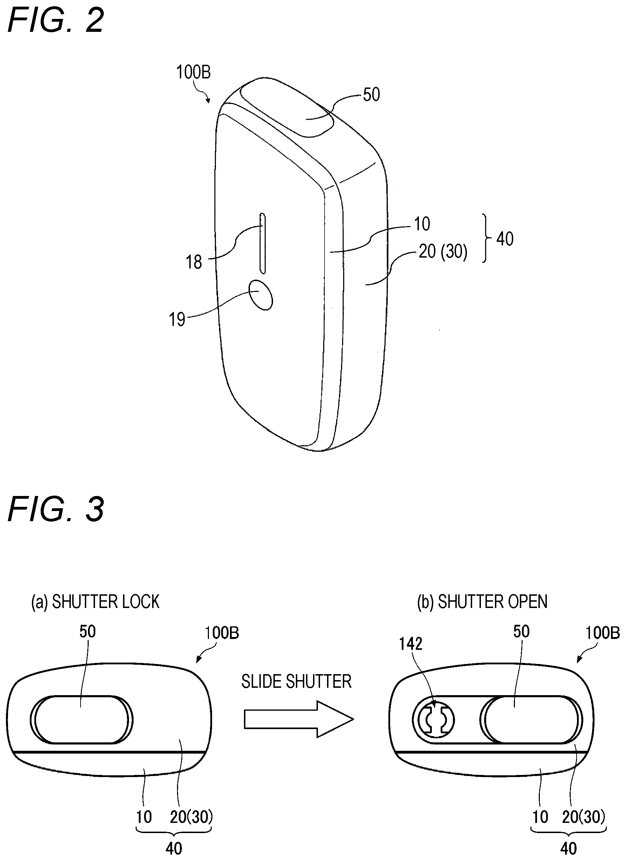

FIG. 2 is an overall perspective view of the inhalation device 100B. FIG. 3 illustrate top views of the inhalation device 100B, and specifically, (a) of FIG. 3 illustrates the inhalation device 100B in a state where the opening 142 is closed by a shutter 50 to be described later, and (b) of FIG. 3 illustrates the inhalation device 100B in a state where the opening 142 is opened.

As illustrated in FIGS. 2 and 3, the inhalation device 100B includes the panel 10, the main body housing 20 to which the panel 10 is detachably attached, and the shutter 50 which is slidable (in other words, movable) with respect to the main body housing 20. The panel 10 and the main body housing 20 are formed as separated members.

The panel 10 is an example of an exterior member in the present invention, and is mainly implemented by a member serving as a cover lid that forms at least a part of a housing 40 (to be described later) on the outmost of the inhalation device 100B. As illustrated in FIG. 2, the panel 10 includes, on a surface (outer surface) thereof, a display part 18 and an operation part 19. The display part 18 is made of a transparent material capable of transmitting light. Although details will be described later, the light emitting device 23a as an example of the notification unit 113B is provided inside the inhalation device 100B (inside a main body 30 to be described later). The user can visually recognize the light from the light emitting device 23a from the outer surface of the panel 10 via the display part 18.

For example, the operation part 19 is configured to form a recess toward the main body housing 20. Accordingly, a position of the operation part 19 can be indicated to the user. Further, the position of the operation part 19 may be indicated to the user by printing a predetermined mark (indication) on the surface of the panel 10. Further, the position of the operation part 19 may not be indicated to the user in order to set the operation part 19 (a first operation button 22a to be described later) to be difficult to understand by the user such as a child.

The main body housing 20 accommodates the main body 30 of the inhalation device 100B. Components of the inhalation device 100B illustrated in FIG. 1B are accommodated in, for example, the main body 30. The main body housing 20 and the main body 30 are examples of a main body portion of the present invention.

The panel 10 is attached to the main body housing 20 to form the outermost housing 40 of the inhalation device 100B. For example, the user can make an appearance of the inhalation device 100B match his/her preference by attaching the panel 10 having a design matching his/her preference. Further, since the inhalation device 100B includes the panel 10, even when the main body 30 generates heat, the heat to be released to the outside can be buffered. That is, for example, the panel 10 may function to insulate heat generated from the main body 30(for example, the heating unit 121B).

The housing 40 is preferably sized to be held in a hand of the user. For example, the user holds the inhalation device 100B with one hand while bringing a fingertip into contact with the surface of the panel 10. When the user presses the operation part 19 with the fingertip, the panel 10 is deformed such that the operation part 19 is further recessed toward the main body housing 20. As a result of such deformation of the panel 10, a bottom portion of the operation part 19 comes into contact with the first operation button 22a (to be described later) provided on a surface of the main body housing 20, and the first operation button 22a is pressed down. As an example, the user can power on the inhalation device 100B by pressing down the first operation button 22a by pressing the operation part 19 with a finger.

FIG. 2 and (a) of FIG. 3 illustrate the inhalation device 100B in a state where the opening 142 is closed by the shutter 50. When the inhalation device 100B is in the state illustrated in (a) of FIG. 3, by the user sliding the shutter 50 with a finger, the shutter 50 is moved from above the opening 142 and the opening 142 is opened, as illustrated in (b) of FIG. 3. In this way, by operating the shutter 50 to open the opening 142, the user can insert the stick-type base material 150 into the opening 142.

That is, the shutter 50 is configured to, according to a movement position thereof with respect to the main body housing 20, enter a first state (the state illustrated in (a) of FIG. 3) where the opening 142 is closed and a second state (the state illustrated in (b) of FIG. 3) where the opening 142 is opened.

Further, on an upper surface of the main body housing 20, a second operation button 22b that can be pressed down (that is, can be operated) by the user is provided. The second operation button 22b is an example of a second operation unit of the present invention.

As shown in (a) of FIG. 3, when the shutter 50 is in the first state, the second operation button 22b is covered with the shutter 50 and enters a shielded state where it is difficult for the user to visually recognize the second operation button 22b. Accordingly, the second operation button 22b can be set to the shielded state by using the shutter 50 that closes or opens the opening 142 of the accommodating portion 140 in which the base material (for example, the stick-type base material 150) is accommodated.

On the other hand, as shown in (b) of FIG. 3, the second operation button 22b is not covered with the shutter 50 when the shutter 50 is in the second state. Thus, by setting the shutter 50 to the second state, the user can visually confirm and appropriately operate the second operation button 22b.

### (2) Example of Inhalation Device with Panel Removed

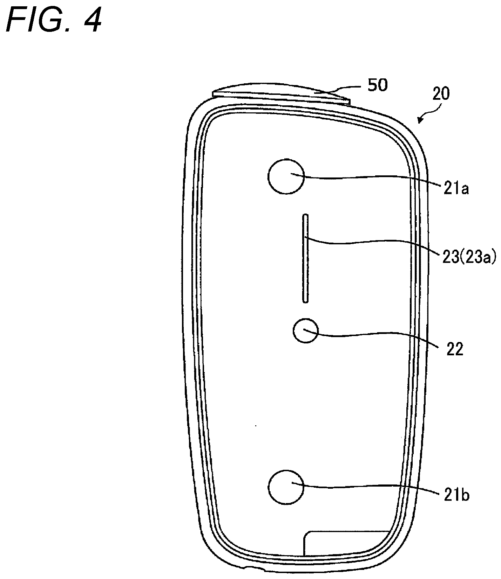

FIG. 4 is a view illustrating the inhalation device 100B in a state where the panel 10 is removed therefrom, and specifically illustrates an outer surface of the main body housing 20 which is exposed when the panel 10 is removed from the main body housing 20. That is, the outer surface of the main body housing 20 illustrated in FIG. 4 is covered with the panel 10 in the state where the panel 10 is attached to the main body housing 20.

As illustrated in FIG. 4, for example, a magnet 21a, a magnet 21b, the first operation button 22a, and a display window 23 are provided on the outer surface of the main body housing 20. In addition to the above parts, for example, a sensor for detecting the attachment of the panel 10 to the main body housing 20 may be provided on the outer surface of the main body housing 20.

The magnet 21a and the magnet 21b attract the panel 10 to the main body housing 20 by magnetic force (magnetic attraction). Accordingly, the panel 10 is held on the main body housing 20. More specifically, magnets (not illustrated) corresponding to the magnet 21a and the magnet 21b are provided on an inner surface of the panel 10 facing the outer surface of the main body housing 20 when the panel 10 is attached to the main body housing 20. Further, the panel 10 is held on the main body housing 20 by the magnets provided on the panel 10, and the magnet 21a and the magnet 21b. Each of the magnet 21a, the magnet 21b, and the magnets of the panel 10 is preferably formed of, for example, a permanent magnet.

The first operation button 22a is an example of a first operation unit of the present invention, and is covered with the panel 10 and enters a shielded state where it is difficult for the user to visually recognize the first operation button 22a, when the panel 10 is attached to the main body housing 20. The first operation button 22a can be operated via the panel 10 when the panel 10 is attached to the main body housing 20.

More specifically, the first operation button 22a is provided at a position corresponding to the operation part 19 of the panel 10 when the panel 10 is attached to the main body housing 20. As described above, by pressing the operation part 19, the operation part 19 can recess toward the main body housing 20 and the user can press down (that is, operate) the first operation button 22a via the bottom portion of the operation part 19. That is, the user can press down the first operation button 22a without removing the panel 10 from the main body housing 20.

The display window 23 is an opening aligned in position with the light emitting device 23a provided in the main body 30, and transmits light from the light emitting device 23a to the display part 18 of the panel 10. Accordingly, as described above, the user can visually recognize the light from the light emitting device 23a from the outer surface of the panel 10.

The light emitting device 23a is an example of a light emitting unit that emits light, and for example, includes one or more light emitting elements. As the light emitting elements of the light emitting device 23a, for example, light emitting diodes (LEDs) may be adopted. As an example, in the present embodiment, the light emitting device 23a includes a plurality of LEDs having different emission colors, and is configured to emit light in a plurality of emission colors including blue, yellow, and red.

The light emitting device 23a notifies the user of predetermined information by emitting light in a predetermined light emitting mode. Here, the light emitting mode can be, for example, a light emission color, but is not limited thereto, and may be, for example, an intensity of lighting (in other words, brightness) or a lighting pattern (for example, blinking at a predetermined time interval).

Examples of the notification performed by the light emitting device 23a include a notification on operation information of the inhalation device 100B indicating whether the power supply of the inhalation device 100B is turned on (that is, in a power-on state). Further, in the present embodiment, the light emitting device 23a may notify the user of information related to the performed operation.

### «3 Operation Example of Inhalation Device>>

Next, an operation example of the inhalation device 100 of the present embodiment will be described. A control unit 116 (116A, 116B) may operate the inhalation device 100 based on an input from the user. As an example, the control unit 116 causes the inhalation device 100 to generate the aerosol in response to an aerosol generation request from the user.

Here, the aerosol generation request can be, for example, an operation (hereinafter, also referred to as a "heating start operation") instructing a start of the heating. As an example, the heating start operation can be a predetermined operation (for example, a release operation to be described later) in a state where the inhalation device 100 is powered on. As another example, the heating start operation may be, for example, an inhalation operation on the inhalation device 100 after the release operation to be described later is performed. The aerosol generation request is not limited to a direct operation on the inhalation device 100, and may be reception of predetermined information from another device capable of communicating with the inhalation device 100, such as a smartphone. The control unit 116 can detect the aerosol generation request based on, for example, information acquired by a sensor unit 112 or a communication unit 115.

For example, in a case where the inhalation device 100 is the inhalation device 100A illustrated in FIG. 1A, when an inhalation operation on the inhalation device 100A is detected based on the detection result of the puff sensor, the control unit 116A supplies a predetermined amount of electric power to the heating unit 121A to generate the aerosol. At this time, the electric power supplied to the heating unit 121A is determined in advance by a manufacturer of the inhalation device 100A in order to generate an appropriate amount of aerosol including an appropriate amount of flavor components, for example. Accordingly, it is possible to provide a high-quality smoking experience to the user.

Further, in a case where the inhalation device 100 is the inhalation device 100B illustrated in FIG. 1B, when the heating start operation (for example, the release operation to be described later) is detected, the control unit 116B controls the temperature of the heating unit 121B based on a heating profile prepared in advance to generate the aerosol. Here, the heating profile is information that defines a time-series transition of a target temperature that is a target value of the temperature of the heating unit 121B, and is stored in advance in the storage unit 114B, for example.

When the temperature control on the heating unit 121B based on the heating profile (hereinafter also referred to as "heating control based on the heating profile") is described in detail, the control unit 116B controls the temperature of the heating unit 121B based on a deviation between the target temperature corresponding to an elapsed time from the start of the heating control based on the heating profile and an actual temperature of the heating unit 121B (hereinafter also referred to as an "actual temperature"). More specifically, at this time, the control unit 116B controls the temperature of the heating unit 121B such that a time-series transition of the actual temperature of the heating unit 121B is the same as the time-series transition of the target temperature defined in the heating profile.

The temperature control on the heating unit 121B can be achieved by, for example, known feedback control. For example, the control unit 116B supplies the electric power from the power supply 111B to the heating unit 121B in a form of pulses subjected to pulse width modulation (PWM) or pulse frequency modulation (PFM). In this case, the control unit 116B can perform the temperature control on the heating unit 121B by adjusting a duty ratio of the power pulses.

In the feedback control, the control unit 116B may control the electric power supplied to the heating unit 121B, for example, the duty ratio based on a difference between the actual temperature and the target temperature and the like. The feedback control may be, for example, proportional-integral-differential controller (PID) control. Alternatively, the control unit 116B may perform simple ON-OFF control. For example, the control unit 116B may perform the heating using the heating unit 121B before the actual temperature reaches the target temperature, stop the heating using the heating unit 121B when the actual temperature reaches the target temperature, and perform the heating using the heating unit 121B again when the actual temperature becomes lower than the target temperature.

The temperature of the heating unit 121B can be acquired (in other words, quantified), for example, by measuring or estimating an electrical resistance value of a heating resistor constituting the heating unit 121B. This is because the electrical resistance value of the heating resistor changes according to the temperature. The electrical resistance value of the heating resistor can be estimated (that is, acquired), for example, by measuring a voltage drop amount in the heating resistor. The voltage drop amount in the heating resistor can be measured (that is, acquired) by a voltage sensor that measures a potential difference applied to the heating resistor. As another example, the temperature of the heating unit 121B may be measured by a temperature sensor (the puff thermistor) provided near the heating unit 121B.

The heating profile is typically designed to optimize a flavor experienced by the user when the user inhales the aerosol generated from the stick-type base material 150. Thus, by controlling the temperature of the heating unit 121B based on the heating profile, it is possible to optimize the flavor experienced by the user, and provide a high-quality smoking experience to the user.

In an inhaler that generates a substance to be inhaled by a user, such as the inhalation device 100, in order to prevent an occurrence of inconvenience caused by misuse by a child of a mischievous age (for example, an infant and a young child who are three years old or younger. Hereinafter, also simply referred to as a "child"), a so-called "child resistance function (hereinafter also referred to as an "CR function")" may be implemented. For example, it is conceivable that, as the CR function in such an inhaler, a predetermined operation such as generating the substance to be inhaled is performed only when a predetermined operation is performed on an operation unit (for example, an operation button) provided in the inhaler.

However, a history of the technical development of the inhaler is still young, and there is a room for improvement in the CR function of the inhaler. It is desirable for the CR function in such an inhaler to be capable of preventing the occurrence of inconvenience caused by the misuse by the child, without compromising convenience for an adult who is a legitimate user as much as possible.

Therefore, in the present embodiment, as described above, the predetermined release operation using the first operation button 22a and the second operation button 22b that can enter the shielded state where it is difficult for the user to visually recognize the both operation buttons is an operation necessary for causing the inhalation device 100 to perform a predetermined operation. That is, the control unit 116 restricts the predetermined operation in the inhalation device 100 until the predetermined release operation using the first operation button 22a and the second operation button 22b is performed.

Therefore, according to the present embodiment, it is difficult for a user, such as a child, who does not know in advance the presence of the first operation button 22a and the second operation button 22b to perform the release operation, and the inhalation device 100 can be prevented from performing the predetermined operation for such a user. Accordingly, an occurrence of inconvenience caused by misuse by such a user can be prevented.

On the other hand, according to the present embodiment, the release operation can be relatively easily performed by a legitimate user assumed to know the presence of the first operation button 22a and the second operation button 22b in advance. Accordingly, even if the release operation is required in order to cause the inhalation device 100 to perform the predetermined operation, a decrease in the convenience of the inhalation device 100 for the legitimate user can be prevented.

As described above, according to the present embodiment, the occurrence of inconvenience caused by the misuse by the child can be prevented, without compromising the convenience for the adult who is the legitimate user as much as possible. Accordingly, a performance of the CR function in the inhalation device 100 is improved, and marketability of the inhalation device 100 is improved.

Hereinafter, the operation example of the inhalation device 100 will be described more specifically. As an example, hereinafter, it is assumed that the release operation is an operation of (A) pressing down one operation button of the first operation button 22a and the second operation button 22b, (B) also pressing down the other operation button within a predetermined time (here, Ta [s]) since the one operation button is pressed down, and (C) continuing pressing down both the first operation button 22a and the second operation button 22b for a predetermined time (here, Tb [s]) or more.

That is, for example, the user can perform the release operation by pressing down the first operation button 22a, also pressing down the second operation button 22b before Ta [s] elapses while the first operation button 22a is being pressed down, and maintaining the press-down state for Tb [s] or more.

In this way, the release operation is an operation that does not include a simultaneous operation on the first operation button 22a and the second operation button 22b, thus preventing the release operation from becoming a complicated or difficult operation for the adult (that is, the legitimate user). Here, the simultaneous operation on the first operation button 22a and the second operation button 22b is an operation of simultaneously starting the press-down of the first operation button 22a and the second operation button 22b.

The contents of the release operation are not limited to the above example. For example, instead of the above example, the release operation may be an operation of (A) pressing down one operation button of the first operation button 22a and the second operation button 22b, then (B) pressing down the one operation button again, and thereafter (C) also pressing down the other operation button. The contents of the release operation may be determined in advance by the manufacturer of the inhalation device 100 or the like, or may be set by the user.

In the present embodiment, the operation to be restricted until the release operation is performed is generating the aerosol. That is, in the present embodiment, the heating control on the heating unit 121 such as generating the aerosol (hereinafter, also simply referred to as "heating control on the heating unit 121") is restricted until the release operation is performed. In other words, in the present embodiment, the power supply to the heating unit 121 such as generating the aerosol is restricted until the release operation is performed. Accordingly, the aerosol can be prevented from being generated for a user such as a child who does not perform the release operation.

The operation to be restricted until the release operation is performed is not limited to the heating control on the heating unit 121 (that is, the generation of the aerosol). For example, an operation of turning on the power supply of the inhalation device 100 (that is, an operation of activating the inhalation device 100) may be restricted until the release operation is performed. That is, the power supply of the inhalation device 100 may not be turned on until the release operation is performed. In other words, the release operation may be an operation for powering on the inhalation device 100. Further, for example, all operations other than an operation of receiving the input of the release operation may be restricted until the release operation is performed.

When the inhalation device 100 performs various operations such as generating the aerosol, the main body 30 of the inhalation device 100 may generate heat. Therefore, from a viewpoint of safety, it is not preferable to cause the inhalation device 100 to perform various operations in a state where the panel 10 capable of insulating (in other words, buffering) the heat from the main body 30 is not attached to the main body housing 20 accommodating the main body 30.

Therefore, in the present embodiment, when the release operation is performed in a case where the panel 10 is attached to the main body housing 20, the control unit 116 causes the inhalation device 100 to generate the aerosol (that is, the predetermined operation). In other words, even if the release operation is performed when the panel 10 is not attached to the main body housing 20, the control unit 116 does not cause the inhalation device 100 to generate the aerosol. More specifically, the control unit 116 performs the heating control on the heating unit 121 under a further condition that it is determined, based on a detection result of the panel detection sensor, that the panel 10 is attached to the main body housing 20.

In this way, by causing the inhalation device 100 to perform the predetermined operation such as generating the aerosol under the condition that the panel 10 is attached to the main body housing 20, the aerosol or the like can be prevented from being generated when the panel 10 that may function as a heat insulating material is not attached to the main body housing 20, and the safety is improved. In each example of the specific operations of the inhalation device 100 to be described below, it is assumed that the panel 10 is attached to the main body housing 20.

Further, when the heating using the heating unit 121 (that is, power supply to the heating unit 121) is performed even though the base material including the aerosol source is not attached to the inhalation device 100, the temperature of the heating unit 121 becomes too high, leading to a waste of electric power in the inhalation device 100.

Therefore, in the present embodiment, when the release operation is performed in a case where the base material including the aerosol source is attached to the inhalation device 100, the control unit 116 causes the inhalation device 100 to generate the aerosol. In other words, even if the release operation is performed when the base material including the aerosol source is not attached to the inhalation device 100, the control unit 116 does not cause the inhalation device 100 to generate the aerosol.

For example, in the case where the inhalation device 100 is the inhalation device 100B illustrated in FIG. 1B, the control unit 116B causes the inhalation device 100B to generate the aerosol when the release operation is performed in a case where the stick-type base material 150 is accommodated in the accommodating portion 140. Further, in the case where the inhalation device 100 is the inhalation device 100A illustrated in FIG. 1A, the control unit 116A causes the inhalation device 100A to generate the aerosol when the release operation is performed in a case where the cartridge 120 and the flavor imparting cartridge 130 are accommodated in the accommodating portion capable of accommodating the cartridge 120 and the flavor imparting cartridge 130.

An attachment state of the cartridge 120, the flavor imparting cartridge 130, or the stick-type base material 150 can be detected, for example, by configuring the sensor unit 112 to include a sensor capable of detecting an electrostatic capacity, a pressure (internal pressure) inside the inhalation device 100, or an inductance that changes according to the presence or absence of the cartridge 120, the flavor imparting cartridge 130, or the stick-type base material 150. As another example, the attachment state may be detected by configuring the sensor unit 112 to include an optical sensor capable of detecting the cartridge 120, the flavor imparting cartridge 130, or the stick-type base material 150. As another example, information indicating whether the cartridge 120, the flavor imparting cartridge 130, or the stick-type base material 150 is attached may be input by the user.

In this way, by causing the inhalation device 100 to generate the aerosol under a condition that the base material including the aerosol source is attached to the inhalation device 100, an operation for generating the aerosol in a state where the base material is not attached to the inhalation device 100 can be prevented, and it is possible to prevent the waste of the electric power of the inhalation device 100 caused by the operation being performed or to prevent the temperature of the heating unit 121 from being too high. In each example of the specific operations of the inhalation device 100 to be described below, it is assumed that the base material including the aerosol source is attached to the inhalation device 100 (for example, the stick-type base material 150 is accommodated in the accommodating portion 140).

### (1) First Example of Specific Operations of Inhalation Device 100

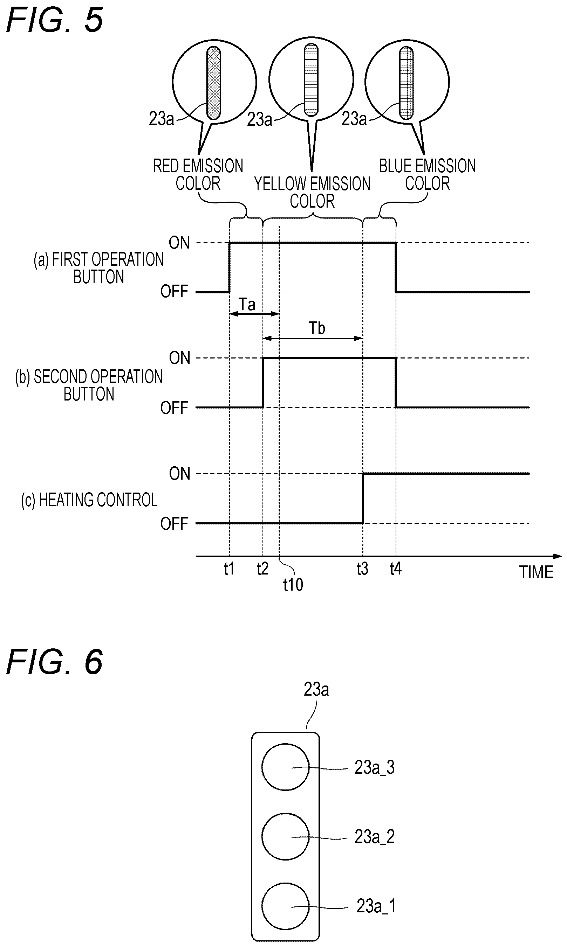

FIG. 5 is a diagram illustrating a first example of the specific operations of the inhalation device 100. A horizontal axis in FIG. 5 represents a time. (a) of FIG. 5 represents ON (operation)/OFF (no operation) of the first operation button 22a at each time indicated by the horizontal axis of FIG. 5. (b) of FIG. 5 represents ON (operation)/OFF (no operation) of the second operation button 22b at each time indicated by the horizontal axis of FIG. 5. (c) of FIG. 5 represents heating control ON (heating control)/OFF (no heating control) of the heating unit 121 at each time indicated by the horizontal axis of FIG. 5.

In the example illustrated in FIG. 5, the user presses down the first operation button 22a at a time t1 at which the heating control on the heating unit 121 is not performed (that is, OFF). When the first operation button 22a is pressed down, information indicating that the first operation button 22a is pressed down is acquired by the sensor unit 112 and sent to the control unit 116. Accordingly, the control unit 116 can detect the press-down of the first operation button 22a from the time t1.

Then, the user also presses down the second operation button 22b from a time t2 while pressing down the first operation button 22a. Here, the time t2 is a time before a time t10 which is a time Ta [s] (for example, 1 [s]) after the time t1. When the second operation button 22b is pressed down, information indicating that the second operation button 22b is pressed down is acquired by the sensor unit 112 and sent to the control unit 116. Accordingly, the control unit 116 can detect the press-down of the second operation button 22b from the time t2.

Then, until a time t3, the user maintains the state where both the first operation button 22a and the second operation button 22b are pressed down. Here, the time t3 is a time Tb [s] (for example, 3 [s]) after the time t2. In this case, the control unit 116 determines that the release operation is performed (in other words, the release operation is completed) at the time t3, and starts the heating control on the heating unit 121. Accordingly, for example, the aerosol is generated at a predetermined time after the time t3, and the user can inhale the generated aerosol.

After the heating control on the heating unit 121 is started (that is, after the release operation is completed), the user may appropriately end the operation on the first operation button 22a and the second operation button 22b. In the example illustrated in FIG. 5, at a time t4 immediately after the time t3, the user ends the press-down of the first operation button 22a and the second operation button 22b.

As illustrated in FIG. 5, the control unit 116 starts the heating control on the heating unit 121 under a condition that the release operation using both the first operation button 22a and the second operation button 22b is performed. Accordingly, the heating using the heating unit 121 is restricted until the release operation is performed, and the aerosol can be prevented from being generated for a user such as a child who does not perform the release operation.

From a viewpoint of improving the convenience of the inhalation device 100, good operability is required. For example, it is considered to improve the operability such that, if the user is notified that an operation on the inhalation device 100 is received in response to the operation, the user can grasp that his/her operation input is succeeded.

Therefore, when an operation is performed on at least one of the first operation button 22a and the second operation button 22b, the control unit 116 preferably notifies the user of information related to the performed operation via the notification unit 113. Here, the information related to the performed operation may be, for example, information indicating contents of the performed operation (in other words, contents of the operation received by the inhalation device 100). The information related to the performed operation is not limited to the above-described example, and may be, for example, information simply indicating that an operation is performed.

As an example, as illustrated in FIG. 5, the control unit 116 notifies the user of the information related to the performed operation, by controlling the light emitting mode of the light emitting device 23a in conjunction with the operation on the first operation button 22a and the second operation button 22b.

More specifically, in the example illustrated in FIG. 5, when only one operation button of the first operation button 22a and the second operation button 22b (here, the first operation button 22a) is pressed down, the control unit 116 causes the light emitting device 23a to emit red light (refer to a period from the time 1 to the time t2).

Further, when both the first operation button 22a and the second operation button 22b are pressed down and before Tb [s] elapses since the press-down of the both operation buttons is started, the control unit 116 causes the light emitting device 23a to emit yellow light (refer to a period from the time 2 to the time t3).

Further, when both the first operation button 22a and the second operation button 22b are pressed down and after Tb [s] elapses since the press-down of the both operation buttons is started, that is, after the release operation is completed and the heating control on the heating unit 121 is started, the control unit 116 causes the light emitting device 23a to emit blue light (refer to a period from the time 3 to the time t4).

In this way, by making the light emitting mode (here, the emission color) of the light emitting device 23a different according to the performed operation, the control unit 116 can notify the user of the information related to the performed operation in an intuitive and easy-to-understand manner. By notifying the user of the information related to the performed operation, the user can grasp that his/her operation input is succeeded, and the operability of the inhalation device 100 is improved.

Here, the emission color of the light emitting device 23a is made different in conjunction with the operation on the first operation button 22a and the second operation button 22b. Hereinafter, an example will be described in which an operation of the light emitting device 23a in addition to the emission color is made different in conjunction with the operation on the first operation button 22a and the second operation button 22b.

### (2 -1) Modification of Light Emitting Device 23a

FIG. 6 is a diagram showing a modification of the light emitting device 23a. In the example illustrated in FIG. 6, the light emitting device 23a includes a first light emitting element 23a_1, a second light emitting element 23a_2, and a third light emitting element 23a_3. For example, LEDs may be adopted as the first light emitting element 23a_1, the second light emitting element 23a_2, and the third light emitting element 23a_3. Emission colors of the first light emitting element 23a_1, the second light emitting element 23a_2, and the third light emitting element 23a_3 may be the same or different.

### (2-2) Second Example of Specific Operations of Inhalation Device 100

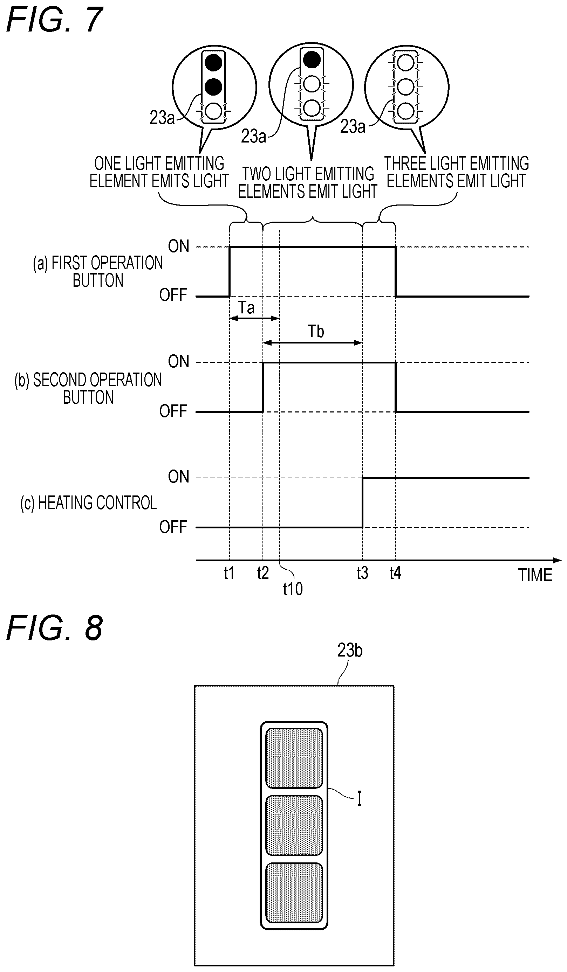

FIG. 7 is a diagram illustrating a second example of the specific operations of the inhalation device 100. Here, portions different from the description of FIG. 5 will be mainly described, and description of portions common to the description of FIG. 5 will be omitted or simplified as appropriate.

In the example illustrated in FIG. 7, the control unit 116 makes the number of light emitting elements that emit light among the light emitting elements provided in the light emitting device 23a different, for example, in conjunction with the operation on the first operation button 22a and the second operation button 22b.

More specifically, in the example illustrated in FIG. 7, when only one operation button of the first operation button 22a and the second operation button 22b (here, the first operation button 22a) is pressed down, the control unit 116 causes one light emitting element (for example, the first light emitting element 23a_1) among the light emitting elements provided in the light emitting device 23a to emit light (refer to the period from the time 1 to the time t2).

Further, when both the first operation button 22a and the second operation button 22b are pressed down and before Tb [s] elapses since the press-down of the both operation buttons is started, the control unit 116 causes two light emitting elements (for example, the first light emitting element 23a_1 and the second light emitting element 23a_2) among the light emitting elements provided in the light emitting device 23a to emit light (refer to the period from the time 2 to the time t3).

Further, when both the first operation button 22a and the second operation button 22b are pressed down and before Tb [s] elapses since the press-down of the both operation buttons is started, that is, after the release operation is completed and the heating control on the heating unit 121 is started, the control unit 116 causes three light emitting elements (that is, the first light emitting element 23a_1, the second light emitting element 23a_2, and the third light emitting element 23a_3) among the light emitting elements provided in the light emitting device 23a to emit light (refer to the period from the time 3 to the time t4).

In this way, by making the number of light emitting elements that emit light among the light emitting elements provided in the light emitting device 23a different according to the performed operation, the control unit 116 can also notify the user of the information related to the performed operation in an intuitive and easy-to-understand manner.

Here, the number of light emitting elements that emit light among the light emitting elements provided in the light emitting device 23a are made different in conjunction with the operation on the first operation button 22a and the second operation button 22b, but the present invention is not limited thereto. For example, the control unit 116 may make the light emitting element that emits light among the light emitting elements provided in the light emitting device 23a different in conjunction with the operation on the first operation button 22a and the second operation button 22b.

More specifically, when only one operation button of the first operation button 22a and the second operation button 22b is pressed down, the control unit 116 may cause the first light emitting element 23a_1 among the light emitting elements provided in the light emitting device 23a to emit light.

Further, when both the first operation button 22a and the second operation button 22b are pressed down and before Tb [s] elapses since the press-down of the both operation buttons is started, the control unit 116 may cause the second light emitting element 23a_2 among the light emitting elements provided in the light emitting device 23a to emit light.

Further, when both the first operation button 22a and the second operation button 22b are pressed down and after Tb [s] elapses since the press-down of the both operation buttons is started, that is, after the release operation is completed and the heating control on the heating unit 121 is started, the control unit 116 may cause the third light emitting element 23a_3 among the light emitting elements provided in the light emitting device 23a to emit light.

In this way, by making the light emitting element that emits light among the light emitting elements provided in the light emitting device 23a different in conjunction with the operation on the first operation button 22a and the second operation button 22b, the information related to the performed operation can also be notified to the user in an intuitive and easy-to-understand manner.

In a case where the notification unit 113 includes a display unit that displays an image, a display mode of the display unit may also be made different in conjunction with the operation on the first operation button 22a and the second operation button 22b. Hereinafter, an example will be described in which a display mode of the display device 23b as an example of the display unit provided in the notification unit 113 is made different in conjunction with the operation on the first operation button 22a and the second operation button 22b.

### (3-1) Example of Display Device 23b

FIG. 8 is a diagram illustrating an example of the display device 23b. The display device 23b is provided at a position in the inhalation device 100 that is visible to the user (for example, always visible). As the display device 23b, for example, a liquid crystal display or an organic electro-luminescence (EL) display may be adopted. The display device 23b displays an indicator I that can be displayed in three stages, for example, one-stage display, two-stage display, and three-stage display.

### (3-2) Third Example of Specific Operations of Inhalation Device 100

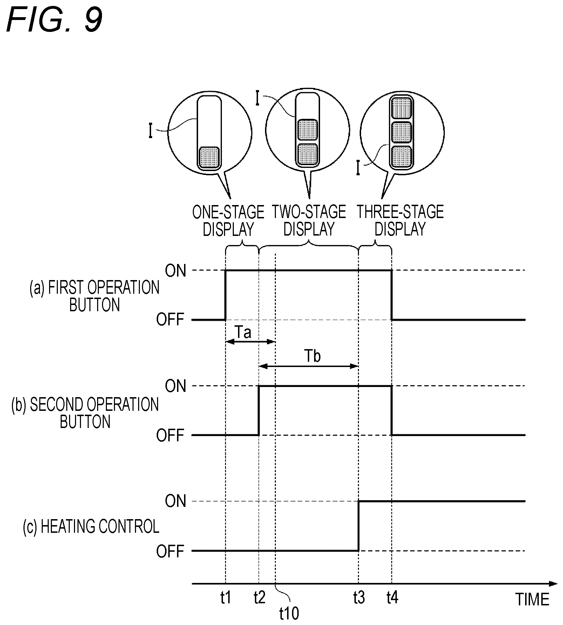

FIG. 9 is a diagram illustrating a third example of the specific operations of the inhalation device 100. Here, portions different from the description of FIG. 5 will be mainly described, and description of portions common to the description of FIG. 5 will be omitted or simplified as appropriate.

In the example illustrated in FIG. 9, the control unit 116 makes the display mode of the indicator I of the display device 23b different in conjunction with the operation on the first operation button 22a and the second operation button 22b.

More specifically, in the example illustrated in FIG. 9, when only one operation button of the first operation button 22a and the second operation button 22b (here, the first operation button 22a) is pressed down, the control unit 116 displays the indicator I in the one-stage display (refer to the period from the time 1 to the time t2).

Further, when both the first operation button 22a and the second operation button 22b are pressed down and before Tb [s] elapses since the press-down of the both operation buttons is started, the control unit 116 displays the indicator I in the two-stage display (refer to the period from the time 2 to the time t3).

Further, when both the first operation button 22a and the second operation button 22b are pressed down and after Tb [s] elapses since the press-down of the both operation buttons is started, that is, after the release operation is completed and the heating control on the heating unit 121 is started, the control unit 116 displays the indicator I in the three-stage display (refer to the period from the time 3 to the time t4).

In this way, by making the display mode of the display device 23b different in conjunction with the operation on the first operation button 22a and the second operation button 22b, the information related to the performed operation can also be notified to the user in an intuitive and easy-to-understand manner.

When the notification unit 113 includes a vibration device (so-called vibrator) that vibrates, the control unit 116 may notify the user of the information related to the performed operation, by making a vibration mode of the vibration device different in conjunction with the operation on the first operation button 22a and the second operation button 22b. In this case, the number of times of vibration or a vibration pattern of the vibration device may be changed according to the performed operation.

Further, when the notification unit 113 includes a sound output device (for example, a speaker) that outputs sound, the control unit 116 may notify the user of the information related to the performed operation by making the sound output from the sound output device different in conjunction with the operation on the first operation button 22a and the second operation button 22b.

### (4) Fourth Example of Specific Operations of Inhalation Device 100

A certain amount of time is required for he heating unit 121 (for example, the heating unit 121B) that heats the aerosol source to reach a temperature sufficient to generate the aerosol. From a viewpoint of preventing a decrease in the convenience of the inhalation device 100, it is desirable that a time until the user can inhale the aerosol is as short as possible.

Therefore, it is preferable that, the control unit 116 starts the heating using the heating unit 121 within a range in which the aerosol is not generated, when the predetermined operation included in the release operation is performed and before the release operation is completed, and causes the heating unit 121 to generate the aerosol when the release operation is completed.

In this way, before the release operation is completed, the temperature of the heating unit 121 can be increased in advance within a range in which the aerosol is not generated. Accordingly, after the release operation is completed, a time required to raise the heating unit 121 up to a temperature at which the aerosol is generated can be shortened. Thus, even if the release operation is required in order to generate the aerosol, the time until the user can inhale the aerosol can be prevented from being lengthened, and the decrease in convenience caused by the lengthening of the time can be prevented.

Hereinafter, the heating control on the heating unit 121 such as generating the aerosol (that is, the heating control on the heating unit 121 described so far) is also referred to as "main heating control". The heating control for raising the heating unit 121 within the range in which the aerosol is not generated is also referred to as "preheating control".

For example, the main heating control can be heating control in which a temperature higher than a lowest temperature at which the aerosol is generated (hereinafter, also simply referred to as the "lowest temperature") is set as the target temperature. Meanwhile, the preheating control can be heating control in which a temperature lower than the lowest temperature is set as the target temperature. The lowest temperature is determined according to physical properties and the like of the aerosol source, and can be, for example, 230°C. The target temperature in the preheating control is set to a temperature (for example, 100°C) higher than a so-called room temperature (for example, 300 [K] = 27°C).

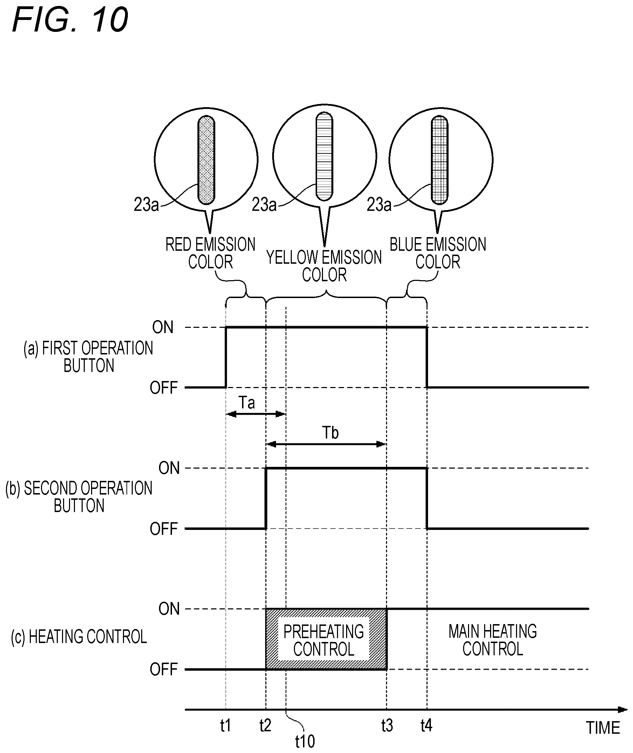

FIG. 10 is a diagram illustrating a fourth example of the specific operations of the inhalation device 100. Here, portions different from the description of FIG. 5 will be mainly described, and description of portions common to the description of FIG. 5 will be omitted or simplified as appropriate.

As illustrated in FIG. 10, for example, the control unit 116 starts the preheating control from the time t2 when both the first operation button 22a and the second operation button 22b are pressed down. Further, when the state where both the first operation button 22a and the second operation button 22b are pressed down is maintained until the time t3, the control unit 116 ends the preheating control and starts the main heating control.

In this way, the preheating control is performed from the time t2 before the time t3 at which the main heating control is started, and thus the temperature of the heating unit 121 can be increased in advance before the main heating control is started. Accordingly, after the main heating control is started, the heating unit 121 can be quickly raised to the temperature at which the aerosol is generated, and the time until the user can inhale the aerosol is shortened.

Further, as described above, the preheating control is performed from the time t2 when both the first operation button 22a and the second operation button 22b are pressed down, and thus the preheating control can be appropriately performed.

For example, it is assumed that the preheating control is performed from the time t1 when only the first operation button 22a is pressed down. In this case, the preheating control is performed even if the first operation button 22a is accidentally pressed down due to mischief of a child or the like, which may result in a waste of the electric power in the inhalation device 100. On the other hand, when the time at which the preheating control is started is set to a time after the time t2, there is a concern that the temperature of the heating unit 121 cannot be sufficiently raised before the time t3 (that is, before the main heating control is started). Thus, in such a case, it is difficult to shorten the time until the user can inhale the aerosol.

Meanwhile, the preheating control is performed from the time t2 when both the first operation button 22a and the second operation button 22b are pressed down, and thus the preheating control can be prevented from being performed due to the mischief of the children or the like, and the waste of the electric power in the inhalation device 100 can be prevented. Further, the temperature of the heating unit 121 can be sufficiently increased before the main heating control is started, and the time until the user can inhale the aerosol is shortened.

### «4. Example of Processing Performed by Control Unit»

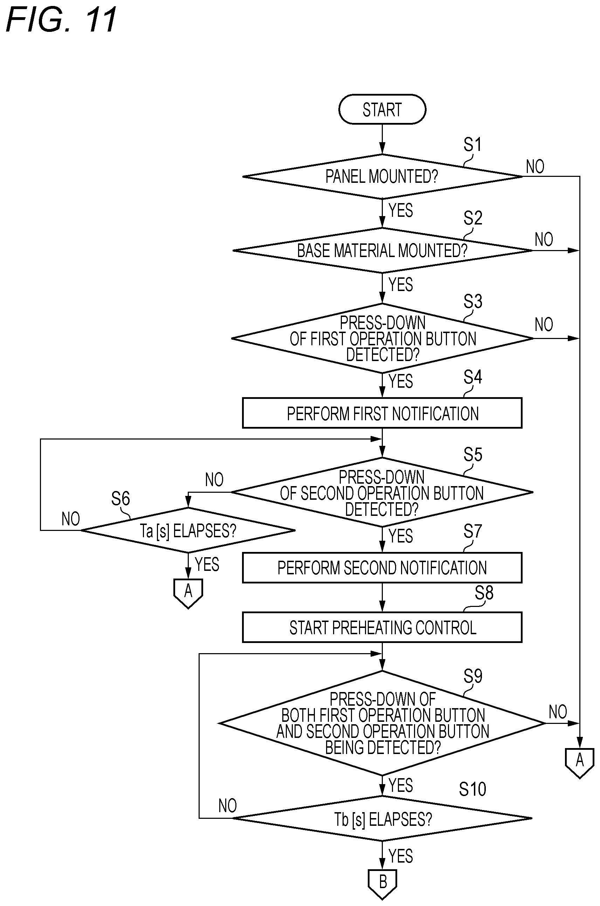

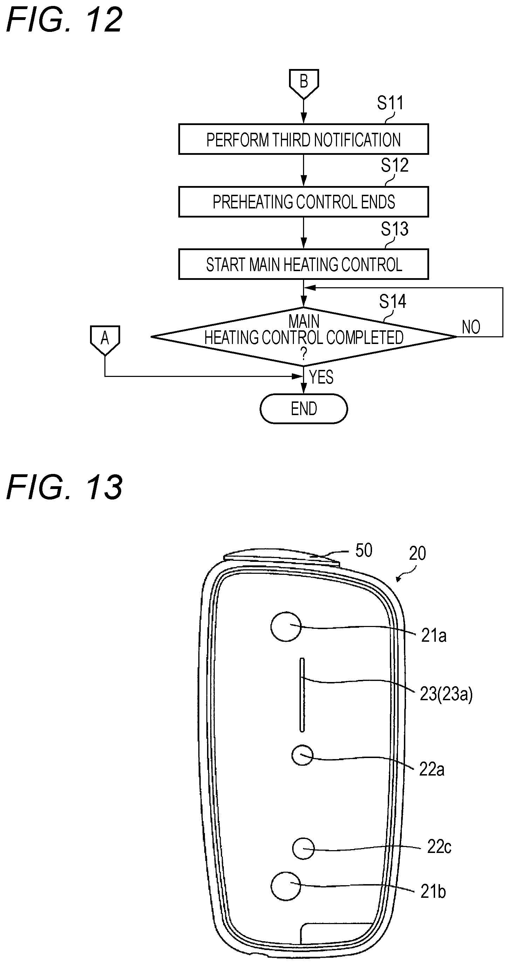

Next, an example of processing performed by the control unit 116 will be described. FIG. 11 is a flowchart (part 1) illustrating an example of the processing performed by the control unit 116. FIG. 12 is a flowchart (part 2) illustrating an example of the processing performed by the control unit 116. As an example, hereinafter, the inhalation device 100 of the present embodiment will be described as being the inhalation device 100B illustrated in FIG. 1B. For example, when the power supply of the inhalation device 100B is turned on, the control unit 116B of the inhalation device 100B performs the series of processing illustrated in FIGS. 11 and 12 at a predetermined cycle.

As illustrated in FIG. 11, the control unit 116B determines whether the panel 10 is in the attached state (step S1). When it is determined that the panel 10 is not in the attached state (step S1: No), the control unit 116B ends the series of processing illustrated in FIGS. 11 and 12.

When it is determined that the panel 10 is in the attached state (step S1: Yes), the control unit 116B determines whether the stick-type base material 150 is in the attached state (step S2). When it is determined that the stick-type base material 150 is not in the attached state (step S2: No), the control unit 116B ends the series of processing illustrated in FIGS. 11 and 12.

When it is determined that the stick-type base material 150 is in the attached state (step S2: Yes), the control unit 116B determines whether the press-down of the first operation button 22a is detected (step S3). When it is determined that the press-down of the first operation button 22a is not detected (step S3: No), the control unit 116B ends the series of processing illustrated in FIGS. 11 and 12.

When it is determined that the press-down of the first operation button 22a is detected (step S3: Yes), the control unit 116B performs a first notification via the notification unit 113B (step S4). Here, the first notification can be, for example, a notification performed in a period from the time 1 to the time t2, such as causing the light emitting device 23a to emit red light.

Next, the control unit 116B determines whether the press-down of the second operation button 22b is detected (step S5). When it is determined that the press-down of the second operation button 22b is not detected (step S5: No), the control unit 116B determines whether Ta [s] elapses since the detection of the press-down of the first operation button 22a is started (step S6). When it is determined that Ta [s] elapses (step S6: Yes), the control unit 116B ends the series of processing illustrated in FIGS. 11 and 12.

When it is determined that Ta [s] does not elapse (step S6: No), the control unit 116B returns to the processing of step S5. When it is determined that the press-down of the second operation button 22b is detected (step S5: Yes), the control unit 116B performs a second notification via the notification unit 113B (step S7), and starts the preheating control (step S8). Here, the second notification can be, for example, a notification performed in a period from the time 2 to the time t3, such as causing the light emitting device 23a to emit yellow light.

Next, the control unit 116B determines whether the press-down of both the first operation button 22a and the second operation button 22b is being detected (step S9). When it is determined that at least one of the first operation button 22a and the second operation button 22b is not detected (step S9: No), the control unit 116B ends the series of processing illustrated in FIGS. 11 and 12.

When it is determined that the press-down of both the first operation button 22a and the second operation button 22b is being detected (step S9: Yes), the control unit 116B determines whether Tb [s] elapses since the detection of the press-down of both the first operation button 22a and the second operation button 22b is started (step S10). When it is determined that Tb [s] does not elapse (step S10: No), the control unit 116B returns to the processing of step S9.

When it is determined that Tb [s] elapses (step S10: Yes), as illustrated in FIG. 12, the control unit 116B performs a third notification via the notification unit 113B (step S11). Here, the third notification can be, for example, a notification performed in a period from the time 3 to the time t4, such as causing the light emitting device 23a to emit blue light.

Next, the control unit 116B ends the preheating control (step S12), and starts the main heating control (step S13). Then, the control unit 116B waits for completion of the main heating control (step S14: No), and ends the series of processing illustrated in FIGS. 11 and 12, when the main heating control is completed (step S14: Yes).

As described above, according to the present embodiment, a predetermined operation in the inhalation device 100, such as generating the aerosol, is restricted until the release operation using the first operation button 22a and the second operation button 22b that can enter the shielded state where it is difficult for the user to visually recognize the both operation buttons is performed. Accordingly, according to the present embodiment, the occurrence of inconvenience caused by the misuse by the child can be prevented, without compromising the convenience for the adult who is the legitimate user as much as possible. Accordingly, a performance of the CR function in the inhalation device 100 is improved, and marketability of the inhalation device 100 is improved.

In the embodiment described above, two operation buttons including the first operation button 22a and the second operation button 22b are provided as a plurality of operation units that can enter a shielded state where it is difficult for the user to visually recognize the plurality of operation units. For example, in addition to the first operation button 22a and the second operation button 22b, another operation unit may be provided as the plurality of operation units that can enter the shielded state where it is difficult for the user to visually recognize the plurality of operation units.

Hereinafter, a modification of the inhalation device 100 will be described in which, in addition to the first operation button 22a and the second operation button 22b, a third operation button 22c is also provided as the plurality of operation units that can enter the shielded state where it is difficult for the user to visually recognize the plurality of operation units. In the following description, portions different from the description of the embodiment described above will be mainly described, and description of portions common to the description of the embodiment described above will be omitted or simplified as appropriate.

FIG. 13 is a diagram illustrating a modification of the inhalation device 100. FIG. 13 illustrates the inhalation device 100 of the present modification in a state where the panel 10 is removed therefrom. As illustrated in FIG. 13, the inhalation device 100 of the present modification further includes the third operation button 22c.

Similarly to the first operation button 22a, the third operation button 22c is covered with the panel 10 and enters a shielded state when the panel 10 is attached to the main body housing 20. That is, the third operation button 22c is also configured to be covered with the panel 10 and enter a shielded state where it is difficult for the user to visually recognize the third operation button 22c. In the present modification, the user can operate (press down) the third operation button 22c by deforming the panel 10 similarly to the first operation button 22a, by pressing a portion in the panel 10 corresponding to the third operation button 22c.

When the third operation button 22c is provided, the release operation can be an operation using the first operation button 22a, the second operation button 22b, and the third operation button 22c. For example, in this case, the release operation can be an operation of (A) pressing down the first operation button 22a, then (B) pressing down the second operation button 22b, and thereafter (C) also pressing down the third operation button 22c.

In this way, in a case where three operation units are used for the release operation, one operation unit among the three operation units may be provided on the same surface as at least one of the other two operation units in the inhalation device 100 from a viewpoint of preventing the release operation from becoming complicated or highly difficult. In the example shown in FIG. 13, the third operation button 22c is provided on the same surface as the first operation button 22a.

Further, when the third operation button 22c is provided, a first release operation using the first operation button 22a and the second operation button 22b without using the third operation button 22c, and a second release operation using the first operation button 22a, the second operation button 22b, and the third operation button 22c may be provided. Then, the control unit 116 may cause the heating unit 121 to generate the aerosol in a first heating mode when the first release operation is performed, and may cause the heating unit 121 to generate the aerosol in a second heating mode different from the first heating mode when the second release operation is performed.

More specifically, the inhalation device 100 of the present modification performs the main heating control based on the heating profile, as in the inhalation device 100B illustrated in FIG. 1B, for example. In this case, the heating profile used for the main heating control after the first release operation is performed is different from the heating profile used for the main heating control after the second release operation is performed.

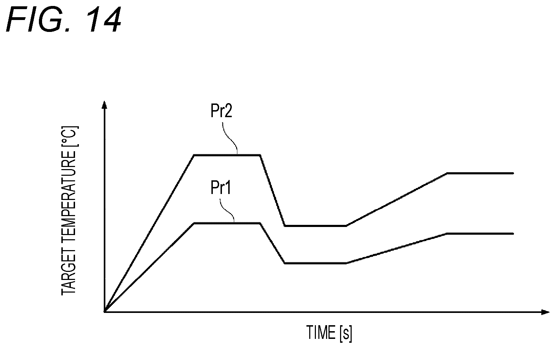

FIG. 14 is a diagram illustrating an example of a first heating profile Pr1 used for the main heating control after the first release operation is performed and a second heating profile Pr2 used for the main heating control after the second release operation is performed. A vertical axis in FIG. 14 represents the target temperature [°C]. The vertical axis in FIG. 14 represents a time [s], and more specifically represents an elapsed time since the heating control based on the heating profile is started.

As illustrated in FIG. 14, the first heating profile Pr1 and the second heating profile Pr2 are different in the target temperature corresponding to the elapsed time, for example. In the example illustrated in FIG. 14, the target temperature corresponding to the elapsed time in the second heating profile Pr2 is higher than that in the first heating profile Pr1.

For example, when the main heating control is performed by performing the first release operation, the control unit 116 of the present modification uses the first heating profile Pr1 in the main heating control. Meanwhile, when the main heating control is performed by performing the second release operation, the control unit 116 uses the second heating profile Pr2 in the main heating control.

Thus, in a case where the first release operation is performed by the user and a case where the second release operation is performed by the user, by subsequently making the heating mode of the heating unit 121 different from each other, smoking experiences with different flavors can be provided. Accordingly, a desired smoking experience can be provided to the user, and the marketability of the inhalation device 100 is improved.

More specifically, in the present modification, the target temperature corresponding to the elapsed time in the second heating profile Pr2 is higher than that in the first heating profile Pr1. Thus, when the second release operation is performed, the inhalation device 100 of the present modification can provide a smoking experience with a stronger flavor as compared with a case where the first release operation is performed. Therefore, by performing the second release operation, the user who desires a strong flavor can obtain a smoking experience with a strong flavor. Meanwhile, by performing the first release operation, the user who desires a reduced flavor can obtain a smoking experience with a reduced flavor.

In the example described above, the heating control based on the first heating profile Pr1 (that is, heating control with a lower target temperature) is performed when the first release operation is performed, and the heating control based on the second heating profile Pr2 (that is, heating control with a higher target temperature) is performed when the second release operation is performed. For example, the heating control based on the second heating profile Pr2 may be performed when the first release operation is performed, and the heating control based on the first heating profile Pr1 may be performed when the second release operation is performed.

Although the embodiments of the present invention have been described above with reference to the accompanying drawings, it is needless to say that the present invention is not limited to such an embodiment. It is apparent to a person skilled in the art that various changes and modifications may be conceived within the scope described in the claims, and it is understood that the changes and the modifications naturally fall within the technical scope of the present invention. In addition, the constituent components described in the above embodiments may be optionally combined without departing from the spirit of the invention.

A control method of the inhalation device 100 described in the above embodiment can be achieved by executing a program prepared in advance on a computer (a processor). The program is stored in a computer-readable storage medium and is executed by being read from the storage medium. Further, the program may be provided in a form of being stored in a non-transitory storage medium such as a flash memory, and may be provided via a network such as the Internet. Although the computer that executes the program can be, for example, a component provided in the inhalation device 100 (for example, the CPU of the inhalation device 100), but is not limited thereto, and may be a component provided in another device (for example, a smartphone or a server device) capable of communicating with the inhalation device 100.

In the present description or the like, at least the following matters are described. In parentheses, corresponding components and the like in the above-described embodiments are illustrated as an example, and the present invention is not limited thereto.
(1) An inhalation device (inhalation device 100, 100A, 100B) that generates an aerosol from a base material (cartridge 120, flavor imparting cartridge 130, stick-type base material 150) including an aerosol source, the inhalation device including:
   a first operation unit (first operation button 22a) and a second operation unit (second operation button 22b) configured to be operated by a user; and
   a control unit (control unit 116, 116A, 116B) configured to control an operation of the inhalation device, in which
   each of the first operation unit and the second operation unit is configured to be covered with another member (panel 10, shutter 50) and enter a shielded state where it is difficult for the user to visually recognize the corresponding operation unit, and
   the control unit restricts a predetermined operation in the inhalation device until a predetermined release operation using the first operation unit and the second operation unit is performed.

According to (1), it is difficult for a user, such as a child, who does not know in advance the presence of the first operation unit and the second operation unit to perform the release operation, and the inhalation device can be prevented from performing the predetermined operation for such a user. Accordingly, an occurrence of inconvenience caused by misuse by such a user can be prevented.

Meanwhile, according to (1), the release operation can be relatively easily performed by a legitimate user who is assumed to know in advance the presence of the first operation unit and the second operation unit. Accordingly, even if the release operation is required in order to cause the inhalation device to perform the predetermined operation, a decrease in convenience of the inhalation device for the legitimate user can be prevented.

(2) The inhalation device according to (1), further including:
a main body portion (main body housing 20, main body 30) on which the first operation unit and the second operation unit are provided; and
an exterior member (panel 10) detachable with respect to the main body portion, in which
the first operation unit is covered with the exterior member and enters the shielded state when the exterior member is attached to the main body portion.

According to (2), the first operation unit can enter the shielded state by using the exterior member that is detachable with respect to the main body portion.

(3) The inhalation device according to (2), in which
the first operation unit is provided to be operable via the exterior member when the exterior member is attached to the main body portion, and
the control unit causes the inhalation device to perform the predetermined operation when the release operation is performed in a case where the exterior member is attached to the main body portion.

When the inhalation device performs the predetermined operation, the main body portion of the inhalation device may generate heat. Therefore, from a viewpoint of safety, it is not preferable to cause the inhalation device to perform the predetermined operation in a state where the exterior member capable of insulating the heat from the main body portion is not attached to the main body portion. According to (3), since the inhalation device performs the predetermined operation when the exterior member is attached to the main body portion, the inhalation device can be prevented from performing the predetermined operation when the exterior member is not attached to the main body portion, and the safety is improved.

(4) The inhalation device according to any one of (1) to (3), further including:
a main body portion (main body housing 20, main body 30) on which the first operation unit and the second operation unit are provided; and
a shutter (shutter 50) movable with respect to the main body portion, in which
the main body portion includes an accommodating portion (accommodating portion 140) having an internal space (internal space 141) configured to allow at least a part of the base material to be accommodated therein and an opening (opening 142) establishing communication between the internal space and an outside,
the shutter is configured to, according to a movement position thereof respect to the main body portion, enter a first state where the opening is closed and a second state where the opening is opened, and
the second operation unit is covered with the shutter and enters the shielded state when the shutter is in the first state, and is not covered with the shutter when the shutter is in the second state.

According to (4), the second operation unit can be set to the shielded state by using the shutter that closes or opens the opening of the accommodating portion in which the base material is accommodated.

(5) The inhalation device according to (4), in which
the control unit causes the inhalation device to perform the predetermined operation when the release operation is performed in a case where the base material is accommodated in the accommodating portion, and
the predetermined operation includes generating the aerosol.

According to (5), an operation for generating the aerosol in a state where the base material is not accommodated in the accommodating portion can be prevented, and a waste of electric power caused by the operation can be prevented.

(6) The inhalation device according to any one of (1) to (5), in which
the release operation is an operation not including a simultaneous operation on the first operation unit and the second operation unit.

According to (6), the release operation can be prevented from becoming a complicated or difficult operation for the legitimate user.

(7) The inhalation device according to any one of (1) to (6), further including:
a notification unit (notification unit 113, 113A, 113B) configured to notify the user of predetermined information, in which
when an operation on at least one of the first operation unit and the second operation unit is performed, the control unit notifies the user of information related to the performed operation via the notification unit.

According to (7), the user can be notified of the information related to the operation in response to the operation being performed on at least one of the first operation unit and the second operation unit. Accordingly, the user can grasp that his/her operation input is succeeded, and operability for the user is improved.

(8) The inhalation device according to (7), in which
the notification unit includes a light emitting unit (light emitting device 23a) configured to emit light, and
the control unit notifies the user of the information related to the performed operation by making a light emitting mode of the light emitting unit different according to the operation.

According to (8), the information related to the performed operation can be notified to the user in an intuitive and easy-to-understand manner.

(9) The inhalation device according to (8), in which
the light emitting unit is configured to emit light in a plurality of emission colors, and
the control unit makes the emission colors of the light emitting unit different according to the performed operation.

According to (9), the information related to the performed operation can be notified to the user in an intuitive and easy-to-understand manner.

(10) The inhalation device according to (8), in which
the light emitting unit includes a plurality of light emitting elements (first light emitting element 23a_1, second light emitting element 23a_2, third light emitting element 23a_3), and
the control unit makes the light emitting element that emits light or the number of light emitting elements that emit light among the plurality of light emitting elements different according to the performed operation.

According to (10), the information related to the performed operation can be notified to the user in an intuitive and easy-to-understand manner.

(11) The inhalation device according to (7), in which
the notification unit includes a display unit (display device 23b) configured to display an image, and
the control unit notifies the user of the information related to the performed operation by making a display mode of the display unit different according to the operation.

According to (11), the information related to the performed operation can be notified to the user in an intuitive and easy-to-understand manner.

(12) The inhalation device according to any one of (1) to (11), further including:
a heating unit (heating unit 121, 121A, 121B) configured to heat the base material to generate the aerosol, in which
the predetermined operation includes generating the aerosol by the heating unit,
when a predetermined operation included in the release operation is performed and before the release operation is completed, the control unit starts the heating using the heating unit within a range in which the aerosol is not generated, and
when the release operation is completed, the control unit causes the heating unit to generate the aerosol.

According to (12), before the release operation is completed, a temperature of the heating unit can be increased in advance within a range in which the aerosol is not generated. Accordingly, after the release operation is completed, a time required to raise the heating unit up to a temperature at which the aerosol is generated can be shortened. Thus, even if the release operation is required in order to generate the aerosol, a time until the user can inhale the aerosol can be prevented from being lengthened, and a decrease in convenience caused by the lengthening of the time can be prevented.

(13) The inhalation device according to any one of (1) to (12), further including:
a heating unit (heating unit 121, 121A, 121B) configured to heat the base material to generate the aerosol; and
a third operation unit (third operation button 22c) configured to be covered with another member and enter a shielded state where it is difficult for the user to visually recognize the third operation unit, in which
the predetermined operation includes generating the aerosol by the heating unit,
when a first release operation using the first operation unit and the second operation unit is performed, the control unit causes the heating unit to generate the aerosol in a first heating mode, and
when a second release operation using the first operation unit, the second operation unit, and the third operation unit is performed, the control unit causes the heating unit to generate the aerosol in a second heating mode different from the first heating mode.

According to (13), in a case where the first release operation is performed by the user and a case where the second release operation is performed by the user, smoking experiences with different flavors can be provided. Accordingly, a desired smoking experience can be provided to the user, and marketability of the inhalation device is improved.

(14) A control method to be performed by a computer (control unit 116, 116A, 116B) for controlling an operation of an inhalation device (inhalation device 100, 100A, 100B) that generates an aerosol from a base material (cartridge 120, flavor imparting cartridge 130, stick-type base material 150) including an aerosol source,
the inhalation device including a first operation unit (first operation button 22a) and a second operation unit (second operation button 22b) configured to be operated by a user,
each of the first operation unit and the second operation unit being configured to be covered with another member (panel 10, shutter 50) and enter a shielded state where it is difficult for the user to visually recognize the corresponding operation unit,
the control method including the computer performing the following processing:
restricting a predetermined operation in the inhalation device until a predetermined release operation using the first operation unit and the second operation unit is performed.

According to (14), it is difficult for a user, such as a child, who does not know in advance the presence of the first operation unit and the second operation unit to perform the release operation, and the inhalation device can be prevented from performing the predetermined operation for such a user. Accordingly, the occurrence of inconvenience caused by the misuse by such a user can be prevented.

Meanwhile, according to (14), the release operation can be relatively easily performed by the legitimate user who is assumed to know in advance the presence of the first operation unit and the second operation unit. Accordingly, even if the release operation is required in order to cause the inhalation device to perform the predetermined operation, the decrease in the convenience of the inhalation device for the legitimate user can be prevented.

(15) A program to be executed by a computer (control unit 116, 116A, 116B) for controlling an operation of an inhalation device (inhalation device 100, 100A, 100B) that generates an aerosol from a base material (cartridge 120, flavor imparting cartridge 130, stick-type base material 150) including an aerosol source,
the inhalation device including a first operation unit (first operation button 22a) and a second operation unit (second operation button 22b) configured to be operated by a user,
each of the first operation unit and the second operation unit being configured to be covered with another member and enter a shielded state where it is difficult for the user to visually recognize the corresponding operation unit,
the program causing the computer to perform the following processing:
   restricting a predetermined operation in the inhalation device until a predetermined release operation using the first operation unit and the second operation unit is performed.

According to (15), it is difficult for a user, such as a child, who does not know in advance the presence of the first operation unit and the second operation unit to perform the release operation, and the inhalation device can be prevented from performing the predetermined operation for such a user. Accordingly, the occurrence of inconvenience caused by the misuse by such a user can be prevented.

Meanwhile, according to (15), the release operation can be relatively easily performed by the legitimate user who is assumed to know in advance the presence of the first operation unit and the second operation unit. Accordingly, even if the release operation is required in order to cause the inhalation device to perform the predetermined operation, the decrease in the convenience of the inhalation device for the legitimate user can be prevented.

### REFERENCE SIGNS LIST

100, 100A, 100B: inhalation device
113, 113A, 113B: notification unit
116, 116A, 116B: control unit
121, 121A, 121B: heating unit
10: panel (exterior member)
22a: first operation button (first operation unit)
22b: second operation button (second operation unit)
22c: third operation button (third operation unit)
23a: light emitting device (light emitting unit)
23a_1: first light emitting element (light emitting element)
23a_2: second light emitting element (light emitting element)
23a_3: third light emitting element (light emitting element)
23b: display device (display unit)
50: shutter

## Claims

1. An inhalation device that generates an aerosol from a base material including an aerosol source, the inhalation device comprising:
a first operation unit and a second operation unit configured to be operated by a user; and
a control unit configured to control an operation of the inhalation device, wherein
each of the first operation unit and the second operation unit is configured to be covered with another member and enter a shielded state where it is difficult for the user to visually recognize the corresponding operation unit, and
the control unit restricts a predetermined operation in the inhalation device until a predetermined release operation using the first operation unit and the second operation unit is performed.

2. The inhalation device according to claim 1, further comprising:
a main body portion on which the first operation unit and the second operation unit are provided; and
an exterior member detachable with respect to the main body portion, wherein
the first operation unit is covered with the exterior member and enters the shielded state when the exterior member is attached to the main body portion.

3. The inhalation device according to claim 2, wherein
the first operation unit is provided to be operable via the exterior member when the exterior member is attached to the main body portion, and
the control unit causes the inhalation device to perform the predetermined operation when the release operation is performed in a case where the exterior member is attached to the main body portion.

4. The inhalation device according to any one of claims 1 to 3, further comprising:
a main body portion on which the first operation unit and the second operation unit are provided; and
a shutter movable with respect to the main body portion, wherein
the main body portion includes an accommodating portion having an internal space configured to allow at least a part of the base material to be accommodated therein and an opening establishing communication between the internal space and an outside,
the shutter is configured to, according to a movement position thereof respect to the main body portion, enter a first state where the opening is closed and a second state where the opening is opened, and
the second operation unit is covered with the shutter and enters the shielded state when the shutter is in the first state, and is not covered with the shutter when the shutter is in the second state.

5. The inhalation device according to claim 4, wherein
the control unit causes the inhalation device to perform the predetermined operation when the release operation is performed in a case where the base material is accommodated in the accommodating portion, and
the predetermined operation includes generating the aerosol.

6. The inhalation device according to any one of claims 1 to 5, wherein
the release operation is an operation not including a simultaneous operation on the first operation unit and the second operation unit.

7. The inhalation device according to any one of claims 1 to 6, further comprising:
a notification unit configured to notify the user of predetermined information, wherein
when an operation on at least one of the first operation unit and the second operation unit is performed, the control unit notifies the user of information related to the performed operation via the notification unit.

8. The inhalation device according to claim 7, wherein
the notification unit includes a light emitting unit configured to emit light, and
the control unit notifies the user of the information related to the performed operation by making a light emitting mode of the light emitting unit different according to the operation.

9. The inhalation device according to claim 8, wherein
the light emitting unit is configured to emit light in a plurality of emission colors, and
the control unit makes the emission colors of the light emitting unit different according to the performed operation.

10. The inhalation device according to claim 8, wherein
the light emitting unit includes a plurality of light emitting elements, and
the control unit makes the light emitting element that emits light or the number of light emitting elements that emit light among the plurality of light emitting elements different according to the performed operation.

11. The inhalation device according to claim 7, wherein
the notification unit includes a display unit configured to display an image, and
the control unit notifies the user of the information related to the performed operation by making a display mode of the display unit different according to the operation.

12. The inhalation device according to any one of claims 1 to 11, further comprising:
a heating unit configured to heat the base material to generate the aerosol, wherein
the predetermined operation includes generating the aerosol by the heating unit,
when a predetermined operation included in the release operation is performed and before the release operation is completed, the control unit starts the heating using the heating unit within a range in which the aerosol is not generated, and
when the release operation is completed, the control unit causes the heating unit to generate the aerosol.

13. The inhalation device according to any one of claims 1 to 12, further comprising:
a heating unit configured to heat the base material to generate the aerosol; and
a third operation unit configured to be covered with another member and enter a shielded state where it is difficult for the user to visually recognize the third operation unit, wherein
the predetermined operation includes generating the aerosol by the heating unit,
when a first release operation using the first operation unit and the second operation unit is performed, the control unit causes the heating unit to generate the aerosol in a first heating mode, and
when a second release operation using the first operation unit, the second operation unit, and the third operation unit is performed, the control unit causes the heating unit to generate the aerosol in a second heating mode different from the first heating mode.

14. A control method to be performed by a computer for controlling an operation of an inhalation device that generates an aerosol from a base material including an aerosol source,
the inhalation device including a first operation unit and a second operation unit configured to be operated by a user,
each of the first operation unit and the second operation unit being configured to be covered with another member and enter a shielded state where it is difficult for the user to visually recognize the corresponding operation unit,
the control method comprising the computer performing the following processing:
restricting a predetermined operation in the inhalation device until a predetermined release operation using the first operation unit and the second operation unit is performed.

15. A program to be executed by a computer for controlling an operation of an inhalation device that generates an aerosol from a base material including an aerosol source,
the inhalation device including a first operation unit and a second operation unit configured to be operated by a user,
each of the first operation unit and the second operation unit being configured to be covered with another member and enter a shielded state where it is difficult for the user to visually recognize the corresponding operation unit, and
the program causing the computer to perform the following processing:
restricting a predetermined operation in the inhalation device until a predetermined release operation using the first operation unit and the second operation unit is performed.
